# EUROPÄISCHE PATENTANMELDUNG

(11) **EP 2 518 497 A1**
(43) Veröffentlichungstag der Anmeldung: **31.10.2012**
(21) Anmeldenummer: 11164256.7
(22) Anmeldetag: 29.04.2011
(51) Int. Cl.: G01N 33/49, G01N 33/487

(54) **Elektrochemisches Sensorelement für Körperflüssigkeiten und Herstellungsverfahren dafür**

(71) Anmelder: Roche Diagnostics GmbH, 68305 Mannheim (DE); F. Hoffmann-La Roche AG, 4070 Basel (CH)
(72) Erfinder: Harttig, Herbert, 67434 Neustadt (DE)
(74) Vertreter: Pfiz, Thomas

(57) **Zusammenfassung**

Die Erfindung betrifft ein Sensorelement (10) zur elektrochemischen Untersuchung einer Körperflüssigkeit sowie ein Herstellungsverfahren dafür. Hierbei wird vorgeschlagen, eine elektrisch leitende Schichtstruktur (14) auf einem nichtleitenden Trägersubstrat (12) aufzubringen, wobei die Schichtstruktur (14) eine durchgängige metallische Grundschicht (26) und eine auf der Grundschicht (26) aufgebaute und diese vollflächig oder bereichsweise überdeckende metallische Deckschicht (28) aufweist, und wobei die Deckschicht (28) im vergleich zur Grundschicht (26) aus edlerem Metall besteht.

## Beschreibung

Die Erfindung betrifft ein Sensorelement zur elektrochemischen Untersuchung einer Probe, insbesondere einer Körperflüssigkeit, mit einem elektrisch isolierenden Trägersubstrat und einer auf der Substratoberfläche aufgebrachten, elektrisch leitenden Schichtstruktur, die eine mit der Probe beaufschlagbare Elektrodenanordnung besitzt. Die Erfindung betrifft weiter ein Herstellungsverfahren für solche Sensorelemente.

Die WO 2009/056299 A1 offenbart einen gattungsgemäßen Biosensor mit verschiedenen Strukturbereichen, in denen das Flächenmuster der Schichtstruktur aus verschiedenen elektrisch leitenden Metallen gebildet ist. Beispielsweise soll ein erster Flächenbereich aus einem ersten elektrisch leitenden Material neben einem zweiten Flächenbereich aus einem zweiten elektrisch leitenden Material auf dem Substrat angeordnet sein. Die verschiedenen Bereiche können an Anschlussstellen von wenigen Millimetern Breite elektrisch leitend aneinander angeschlossen sein. Die verschiedenen Metallschichten der Schichtstruktur stehen somit alle an ihrer Unterseite in flächigem Kontakt mit der Substratoberfläche und müssen auf dieser eigens strukturiert werden. Durch die nur linienförmigen Anschlussstellen können sich variierende Übergangswiderstände ergeben.

Ausgehend hiervon liegt der Erfindung die Aufgabe zugrunde, die im Stand der Technik bekannten Erzeugnisse und Verfahren weiter zu verbessern und eine zuverlässige, einfach herstellbare und materialsparende Bauform für die Massenherstellung von analytischen Verbrauchsmitteln anzugeben.

Zur Lösung dieser Aufgabe wird die in den unabhängigen Patentansprüchen angegebene Merkmalskombination vorgeschlagen. Vorteilhafte Ausgestaltungen und Weiterbildungen der Erfindung ergeben sich aus den abhängigen Ansprüchen.

Die Erfindung geht von dem Gedanken aus, mehrlagige metallische Kombinationsschichten für eine elektrisch leitende Schichtstruktur einzusetzen. Dementsprechend wird erfindungsgemäß vorgeschlagen, dass die Schichtstruktur eine durchgängige metallische Grundschicht und eine insgesamt auf der Grundschicht aufgebaute und diese vollflächig oder bereichsweise überdeckende, im Abstand zu der Substratoberfläche befindliche metallische Deckschicht aufweist, wobei die Grundschicht aus einem ersten, relativ unedlen Metall und die Deckschicht aus einem zweiten, edlen Metall besteht. Das erste Metall der Grundschicht bildet somit durchgängig die gesamte auf der Substratoberfläche haftende Unterseite der auf dem Substrat vorhandenen Schichtstruktur, während die Deckschicht insgesamt keinen Kontakt zu Substratoberfläche besitzt und mit reduzierter Schichtdicke und ggf. begrenzter Flächenausdehnung beispielsweise nur in funktionellen Bereichen materialsparend eingesetzt werden kann. Die unterschiedlichen Schichtmaterialien lassen sich dabei gezielt auf ihre jeweilige Funktion abstimmen, indem die durchgängige Grundschicht robust und elektrisch gut leitend aus relativ preiswertem unedlen Metall und die Deckschicht elektrochemisch inert und in den Oberflächeneigenschaften beständig aus Edelmetall gebildet wird. Ein weiterer besonderer Vorteil besteht darin, dass die Kombinationsschichten im Verbund gemeinsam strukturiert werden können.

Vorteilhafterweise besitzt die Grundschicht eine größere Schichtdicke als die Deckschicht, so dass das Edelmetall möglichst materialsparend eingesetzt werden kann. Dabei ist es auch möglich, die Deckschicht auf bestimmte Funktionsbereiche der Schichtstruktur zu begrenzen, wobei jedenfalls die Deckschicht mehr als 10% der Gesamtfläche der Grundschicht bedeckt.

Um für den Messerfolg besonders wichtige Funktionsbereiche zu optimieren, ist es vorteilhaft, wenn die Elektrodenanordnung und gegebenenfalls ein Kontaktfeldbereich zum elektrischen Anschluss der Elektrodenanordnung zweilagig metallisch ausgebildet sind.

Für elektrochemische Testelemente ist es von besonderem Vorteil, wenn die Deckschicht aus Edelmetall, vorzugsweise Gold, Palladium, Platin oder einer Legierung davon besteht.

Zur Reduzierung des kostenintensiven Materialeinsatzes ist es vorteilhaft, wenn die Deckschicht eine Schichtdicke von weniger als 50 nm, vorzugsweise weniger als 20 nm aufweist.

Eine weitere vorteilhafte Ausgestaltung sieht vor, dass die Grundschicht aus relativ unedlem Metall, vorzugsweise Titan, Aluminium oder einer Legierung oder Kombinationsschicht davon besteht. Titan ist als unedles Metall bevorzugt, da es einfach zu sputtern ist und an Luft eine dünne, dichte, chemisch inerte Oxidschicht bildet. Aufgrund der höheren Leitfähigkeit ist Aluminium eine Alternative zu Titan, jedoch ist die Oxidschicht, die sich auf Aluminium ausbildet, deutlich dicker als bei Titan. Prinzipiell ebenfalls geeignet sind alle Metalle, die an Luft ebenfalls eine dichte, chemisch inerte Oxidschicht ausbilden. Dies sind in erster Linie Tantal, Scandium, Vanadium, Chrom, Kobalt, Nickel, Zirkon, Hafnium, Niob, Wolfram, Rhenium und Molybdän sowie Legierungen davon. Aus Kosten- und Verarbeitungsgründen sind jedoch Titan und Aluminium bevorzugt. Zudem werfen diese beiden Metalle keine toxikologischen Probleme auf.

Vorteilhafterweise besitzt die Grundschicht eine im Wesentlichen konstante Schichtdicke vorzugsweise im Bereich von 50 bis 200 nm.

Für spezifische Tests ist im Bereich der Elektrodenanordnung ein zum elektrochemischen Nachweis eines Analyten in der Probe ausgebildetes Reagenzsystem vorzugsweise schichtförmig angeordnet.

In verfahrensmäßiger Hinsicht wird zur Lösung der eingangs genannten Aufgabe vorgeschlagen, dass die Schichtstruktur aus einer durchgängigen Grundschicht aus Metall und zumindest bereichsweise aus einer auf der Grundschicht aufgebauten Deckschicht aus im Vergleich zum Metall der Grundschicht edlerem Metall gebildet wird.

Eine solche Kombinationsschicht lässt sich in einem für die Massenproduktion geeigneten Prozess dadurch fertigen, dass zunächst die Grundschicht auf dem Trägersubstrat und anschließend die Deckschicht auf der Grundschicht durch sukzessive Beschichtungsprozesse aufgebracht werden. In diesem Zusammenhang ist es besonders bevorzugt, die Grundschicht und die Deckschicht durch Sputterdeposition zu bilden.

Um Funktionsbereiche speziell auszustatten, ist es vorteilhaft, wenn die Deckschicht über eine Maske oder

Blende bereichsweise, vorzugsweise streifenförmig auf die Grundschicht aufgebracht wird.

Günstig ist es auch, die Grundschicht und die Deckschicht gemeinsam durch Materialabtragung von Teilbereichen vorzugsweise durch Laserablation geometrisch zu strukturieren.

Ein weiterer Erfindungsaspekt liegt in der Verwendung einer zweilagigen Schichtstruktur bestehend aus einer

Grundschicht aus Metall und einer Deckschicht aus edlerem Metall, vorzugsweise Edelmetall für die Herstellung von disposiblen elektrochemischen Sensorelementen, insbesondere Teststreifen oder Testbändern für Glukosetests. Solche Tests müssen häufig wiederkehrend möglichst kostengünstig durchgeführt werden, wobei hohe Anforderungen an die Testgenauigkeit gestellt werden und durch die zu untersuchenden Körperflüssigkeiten spezielle Randbedingungen bestehen.

Im Folgenden wird die Erfindung anhand des in der Zeichnung schematisch dargestellten Ausführungsbeispiels näher erläutert. Es zeigen:
- Fig. 1: ein elektrochemisches Sensorelement mit einer bereichsweise zweilagigen metallischen Schichtstruktur in der Draufsicht;
- Fig. 2: das Sensorelement in einem nicht maßstäblichen Längsschnitt entlang der Linie 2 - 2 der Fig. 1;
- Fig. 3: eine schaubildliche Darstellung einer Sputteranlage zur Herstellung der zweilagigen Schichtstruktur.

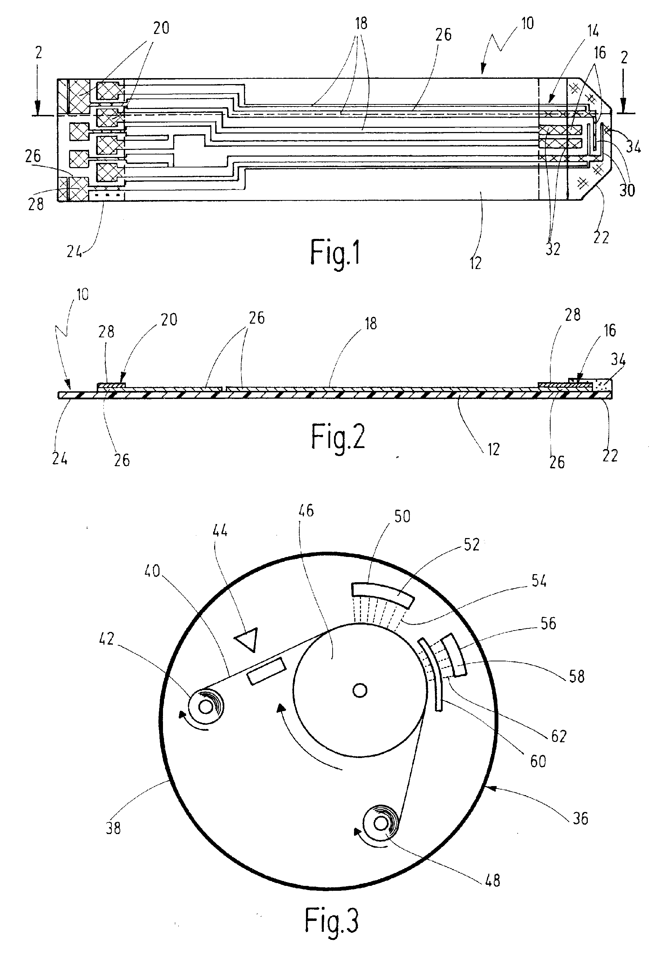

Das in Fig. 1 und 2 schematisch dargestellte Sensorelement 10 dient als Biosensor zur elektrochemischen Untersuchung von Körperflüssigkeiten und insbesondere in Form eines Teststreifens zur Glukosebestimmung in Blut und/oder Gewebeflüssigkeit. Zu diesem Zweck umfasst das Sensorelement 10 ein nichtleitendes streifenförmiges Trägersubstrat 12 und eine darauf aufgebrachte, elektrisch leitende Schichtstruktur 14, die eine mit der Flüssigprobe beaufschlagbare Elektrodenanordnung 16, elektrische Leiterbahnen 18 und Kontaktfelder 20 am Anschlussende der Leiterbahnen 18 aufweist. In den Endabschnitten 22, 24, die in Fig. 1 durch gestrichelte Linien begrenzt sind, ist die Schichtstruktur 14 aus einer dickeren Grundschicht 26 aus unedlem Metall und einer dünneren Deckschicht 28 aus Edelmetall ausgebildet. Hingegen bestehen die Leiterbahnen 18 zwischen den Endabschnitten 22, 24 einlagig nur aus der Grundschicht 26. Die Grundschicht 26 bildet somit durchgängig die gesamte Basis der Schichtstruktur 14.

Wie in Fig. 1 gezeigt, weist die Elektrodenanordnung 16 zwei Messelektroden 30 und zwei Kontrollelektroden 32 auf. Ein trockenchemisches Reagenzsystem 34, das im Bereich zumindest einer der Messelektroden 30 aufgebracht ist, lässt sich mit der Flüssigprobe aufquellen oder lösen, um bei Anlegen einer Spannung zwischen den Messelektroden 30 einen Analyten in der Probe elektrochemisch nachweisen zu können.

Aus Fig. 2 ist deutlich ersichtlich, dass die Elektrodenanordnung 16 in dem eine Messzone bildenden Endabschnitt 22 und die Kontaktfelder 20 in dem geräteseitig anschließbaren Endabschnitt 24 insgesamt zweilagig aus der Grund- und Deckschicht 26, 28 ausgebildet sind und durch einlagige Leiterbahnen 18 in der Grundschicht 26 verbunden sind. Die Grundschicht 26 steht an ihrer Unterseite vollflächig in festhaftendem Kontakt mit der Substratoberfläche, während die Deckschicht 28 insgesamt auf der von dem Trägersubstrat abgewandten Oberseite der Grundschicht 26 aufgebaut ist und keinen Kontakt zur Substratoberfläche hat.

Zweckmäßig besteht die relativ zur Deckschicht 28 dickere Grundschicht 26 aus einem elektrisch gut leitenden, aber im Vergleich zur Deckschicht 28 unedlen und daher relativ preiswerten Metall. Hierfür eignen sich besonders Titan, Aluminium oder Legierungen davon. Eine hinreichend robuste Grundschicht kann eine Schichtdicke beispielsweise von 50 nm besitzen.

Die dünnere Deckschicht 28 sollte gegen Probeneinfluss unempfindlich sein und einen möglichst konstanten Kontaktwiderstand und konstantes elektrochemisches Potential auch über längere Lagerzeiten bieten. Hierfür eignen sich besonders Edelmetalle, besonders bevorzugt Gold, aber auch Palladium, Platin oder Legierungen aus diesen Beschichtungsstoffen. Um Materialkosten zu minimieren, sollte die Deckschicht 28 möglichst dünn sein und beispielsweise eine Schichtdicke von weniger als 20 nm aufweisen.

Das Trägersubstrat 12 kann als Zuschnitt aus einem Kunststoff-Folienmaterial gebildet sein, so dass es sich in einer Massenproduktion einfach verarbeiten lässt und für den Gebrauchszweck hinreichend stabil ist. Das Reagenzsystem 34 kann aus einer Enzymzusammensetzung gebildet sein, die als pastöse Masse auf die Messzone 22 aufgebracht und unter Bildung einer Trockenchemieschicht getrocknet wird. Einzelheiten solcher elektrochemisch-enzymatischer Biosensoren sind dem Fachmann an sich bekannt und brauchen hier nicht näher erläutert zu werden.

Bei dem vorgesehenen Einmalgebrauch wird von einem Benutzer eine Blutprobe auf die Elektrodenanordnung 16 appliziert und sodann der Teststreifen 10 in einem nicht gezeigten Handgerät ausgewertet. Das Gerät legt über die Kontaktfelder 20 ein elektrisches Potential an die Elektrodenanordnung 16 an und erfasst eine Antwort (z.B. Strom, Impedanz, Ladung, etc.), die von der Gegenwart oder Konzentration eines Analyten, speziell Blutglukose abhängt. Nach Gebrauch wird der Teststreifen 10 entsorgt.

Fig. 3 veranschaulicht eine beispielhafte Methode zur Massenherstellung von Substraten 12 mit einer zweilagigen metallischen Schichtstruktur 14 in einer Sputteranlage 36. In einem Vakuumkessel 38 der Sputteranlage 36 wird ein Trägerfolienband 40 von einer Vorratsrolle 42 abgezogen, an einer Corona-Station 44 zur Oberflächenbehandlung vorbeigezogen und über eine Beschichtungswalze 46 auf eine Produktrolle 48 umgelenkt und dort wieder aufgewickelt.

Im Bereich der Beschichtungswalze 46 wird an einer ersten Sputterstation 50 die Grundschicht 26 vollflächig aufgebracht. Zu diesem Zweck wird von zum Beispiel einem Titantarget 52 durch Ionenbeschuss das Targetmaterial abgetragen und die gesputterten Teilchen 54 auf der Folienoberfläche kondensiert, wobei die Grundschicht 26 gebildet wird. Im Zuge des weiteren Bandtransports wird an einer zweiten Sputterstation 56 zum Beispiel ein Goldtarget 58 zerstäubt, um die Deckschicht 28 über der Grundschicht 26 aufzubauen. Für eine bereichsweise Begrenzung der Deckschicht 28 wird eine wassergekühlte Blende 60 eingesetzt, durch deren Öffnungen hindurch das abgesputterte Gold 62 nur in streifenförmigen Bereichen auf die Grundschicht 26 niederschlagen wird. Auf der Blende 60 scheidet sich das nicht benötigte Edelmetall ab und kann leicht wieder zurück gewonnen werden. Zur Vermeidung der Bildung von störenden Oxiden auf der Grundschicht 26 wird die Deckschicht 28 ohne Unterbruch des Vakuums und unter Ausschluss von Sauerstoff unmittelbar nach der Abscheidung der Grundschicht 26 auf dieser abgeschieden; d.h., abhängig von der Transportgeschwindigkeit der Trägerfolie 40, innerhalb von Sekunden.

Die aus dem Vakuumkessel 38 entnommene Produktrolle 48 wird in einer weiteren Verfahrensstufe durch eine Laserstation hindurchgespult, um das geometrische Flächenmuster der Schichtstruktur 14 durch Laserablation zu bilden. Dabei wird Laserlicht auf Abschnitte des Bandmaterials 40 durch eine Maske hindurch flächig eingestrahlt und dadurch das Schichtmaterial außerhalb der gewünschten Schichtstruktur 14 abgetragen. Diese Technik ist an sich bekannt und beispielsweise in der WO-A 2009/056299 beschrieben.

In einer an die Laserablation anschließenden Fertigungsstufe kann das Bandmaterial 40 mit dem Reagenzsystem 34 versehen und in Einzelstreifen 10 zerteilt werden.

Eine auf diese Weise erzeugte Schichtstruktur 14 besitzt beispielsweise eine Grundschicht aus Titan von circa 50 bis 70 nm Dicke, bedeckt mit einer Deckschicht aus Gold von 10 nm Dicke. Gold in dieser Dicke bildet bereits eine geschlossene Schicht. Im Bereich der Leiterbahnen 18, in denen Titan blank zu liegen kommt, bildet sich durch Einwirkung von Luftsauerstoff eine chemisch inerte, nicht leitende Titandioxidschicht. Durch die kurzfristig sehr hohe Temperatur bei der Laserablation wird die Oxidation von Titan massiv beschleunigt, so dass die Oxidschicht an verbleibenden Kanten und an gebildetem Titanstaub dick genug ausgebildet wird, um chemisch völlig inert zu sein. Bei der Laserablation gebildeter Goldstaub ist ohnehin inert. Anstelle von Gold könnte auch Gold-Palladium als Edelmetall eingesetzt werden. Das hat den Vorteil, dass bereits bei geringeren Dicken eine geschlossene Schicht gebildet wird. Einfach verfügbar sind Gold-PalladiumLegierungen mit 80/20 und 60/40 %.

Wird Platin als Deckschicht auf einer Titan-Grundschicht eingesetzt, sind besonders dünne Schichten von Edelmetall möglich. Bei 2,5 nm Platin auf 50 nm Titan reduzieren sich die Materialkosten der Schichtstruktur pro Test gegenüber reinem Gold um mehr als 90 %. Wird Palladium auf Titan eingesetzt, profitiert man vom günstigeren Preis des Palladium und der Möglichkeit, relativ dünne Schichten zu fertigen.

## Patentansprüche

1. Sensorelement zur elektrochemischen Untersuchung einer Probe, insbesondere einer Körperflüssigkeit, mit einem elektrisch isolierenden Trägersubstrat (12) und einer auf der Substratoberfläche aufgebrachten, elektrisch leitenden Schichtstruktur (14), die eine mit der Probe beaufschlagbare Elektrodenanordnung (16) besitzt, **dadurch gekennzeichnet, dass** die Schichtstruktur (14) eine durchgängige metallische Grundschicht (26) und eine auf der Grundschicht (26) aufgebaute und diese vollflächig oder bereichsweise überdeckende metallische Deckschicht (28) aufweist, wobei die Deckschicht (28) im Vergleich zur Grundschicht (26) aus edlerem Metall besteht.

2. Sensorelement nach Anspruch 1, **dadurch gekennzeichnet, dass** die Grundschicht (26) eine größere Schichtdicke als die Deckschicht (28) aufweist.

3. Sensorelement nach Anspruch 1 oder 2, **dadurch gekennzeichnet, dass** die Deckschicht (28) mehr als 10% der Gesamtfläche der Grundschicht (26) bedeckt.

4. Sensorelement nach einem der Ansprüche 1 bis 3, **dadurch gekennzeichnet, dass** die Elektrodenanordnung (16) und gegebenenfalls ein Kontaktfeldbereich (20) zum elektrischen Anschluss der Elektrodenanordnung (16) zweilagig metallisch ausgebildet ist.

5. Sensorelement nach einem der Ansprüche 1 bis 3, **dadurch gekennzeichnet, dass** die Deckschicht (28) aus Edelmetall, vorzugsweise Gold, Palladium, Platin oder einer Legierung davon besteht.

6. Sensorelement nach einem der Ansprüche 1 bis 4, **dadurch gekennzeichnet, dass** die Deckschicht (28) eine Schichtdicke von weniger als 50 nm, vorzugsweise weniger als 20 nm aufweist.

7. Sensorelement nach einem der Ansprüche 1 bis 5, **dadurch gekennzeichnet, dass** die Grundschicht (26) aus unedlem Metall, vorzugsweise Titan, Aluminium oder einer Legierung davon besteht.

8. Sensorelement nach einem der Ansprüche 1 bis 6, **dadurch gekennzeichnet, dass** die Grundschicht (26) eine im Wesentlichen konstante Schichtdicke vorzugsweise im Bereich von 50 bis 200 nm aufweist.

9. Sensorelement nach einem der Ansprüche 1 bis 8, **dadurch gekennzeichnet, dass** im Bereich der Elektrodenanordnung (16) ein zum elektrochemischen Nachweis eines Analyten in der Probe ausgebildetes Reagenzsystem (34) angeordnet ist.

10. Verfahren zur Herstellung eines elektrochemischen Sensorelements (10) nach einem der vorhergehenden Ansprüche bei welchem eine elektrisch leitende Schichtstruktur (14) auf einem elektrisch isolierenden Trägersubstrat (12) aufgebracht wird, **dadurch gekennzeichnet, dass** die Schichtstruktur (14) aus einer durchgängigen Grundschicht (26) aus Metall und zumindest bereichsweise aus einer auf der Grundschicht (26) aufgebauten Deckschicht (28) aus im Vergleich zum Metall der Grundschicht edlerem Metall gebildet wird.

11. Verfahren nach Anspruch 10, **dadurch gekennzeichnet, dass** zunächst die Grundschicht (26) auf dem Trägersubstrat (12) und anschließend die Deckschicht (28) auf der Grundschicht (26) jeweils durch einen Beschichtungsprozess aufgebracht werden.

12. Verfahren nach Anspruch 10 oder 11, **dadurch gekennzeichnet, dass** die Grundschicht (26) und die Deckschicht (28) durch Sputterdeposition gebildet werden.

13. Verfahren nach einem der Ansprüche 10 bis 12, **dadurch gekennzeichnet, dass** die Deckschicht (28) über eine Maske oder Blende (60) bereichsweise, vorzugsweise streifenförmig auf die Grundschicht (26) aufgebracht wird.

14. Verfahren nach einem der Ansprüche 10 bis 13, **dadurch gekennzeichnet, dass** die Grundschicht (26) und die Deckschicht (28) durch Materialabtragung von Teilbereichen vorzugsweise durch Laserablation geometrisch strukturiert werden.

15. Verwendung einer zweilagigen Schichtstruktur (14) bestehend aus einer Grundschicht (26) aus Metall und einer Deckschicht (28) aus edlerem Metall für die Herstellung von disposiblen elektrochemischen Sensorelementen (10), insbesondere Teststreifen oder Testbändern für Glukosetests.
